(19) Europäisches Patentamt
European Patent Office
Office européen des brevets

(11) EP 3 346 454 A1

(12) EUROPEAN PATENT APPLICATION

(43) Date of publication:
11.07.2018 Bulletin 2018/28

(51) Int Cl.:
G08B 13/24 (2006.01)          H01F 10/13 (2006.01)
H01L 41/20 (2006.01)

(21) Application number: 17210712.0

(22) Date of filing: 07.06.2007

(84) Designated Contracting States:
AT BE BG CH CY CZ DE DK EE ES FI FR GB GR
HU IE IS IT LI LT LU LV MC MT NL PL PT RO SE
SI SK TR

(62) Document number(s) of the earlier application(s) in
accordance with Art. 76 EPC:
07798193.4 / 2 188 792

(71) Applicant: Tyco Fire & Security GmbH
8212 Neuhausen am Rheinfall (CH)

(72) Inventors:
• Lian, Ming-Ren
Boca Raton, FL 33428 (US)

• Liu, Nen-Chin
Wellington, FL 33414 (US)
• China, Chaitali
Orlando, FL 32826 (US)
• Coffey, Kevin R.
Oviedo, FL 32766 (US)

(74) Representative: Kohl, Fabian Hanno
Hafner & Kohl
Schleiermacherstraße 25
90491 Nürnberg (DE)

Remarks:
This application was filed on 27.12.2017 as a
divisional application to the application mentioned
under INID code 62.

(54) **AMORPHOUS ALLOY COMPOSITIONS FOR A MAGNETOMECHANICAL RESONATOR AND EAS MARKER CONTAINING SAME**

(57) A method of manufacturing a marker for use in a magnetomechanical electronic article surveillance (EAS) system, the method comprising the steps of:
- providing a magnetomechanical active element formed by planar strip of amorphous magnetostrictive alloy having a composition $Fe_a M_b M_o$ wherein $a+b+c = 100$, wherein a is in a range of 40-70 weight percent, b is in a range of 10-50 weight percent, and c is in a range of 10-50 weight percent, and where M is the balance of remaining elements;
- subjecting the magnetomechanical active element to an annealing process for rearranging of the amorphous material in a short range, microscopic scale.

Figure 7

**Description**

BACKGROUND

This application relates to and claims the benefit of priority from U.S. Provisional Patent Application Serial No. 60/811,280, filed June 6, 2006, entitled "Amorphous Alloy Composition for a Magnetomechanical Resonator and EAS Marker Containing Same," the entire disclosure of which is hereby incorporated by reference herein..

The field of this invention is electronic article surveillance and more particularly a marker for use in an electronic article surveillance system.

There are many different sensing technologies used by retailers' anti-theft applications, known as Electronic Article Surveillance ("EAS"). Among these technologies are acoustomagnetic ("AM") based markers (tags and labels), such as those produced by Sensormatic Electronics Corporation, which are highly desirable due to many of their unique advantages, such as high sensitivities, small size, deactivitible / reactivitible, low cost, easy deactivation, etc.

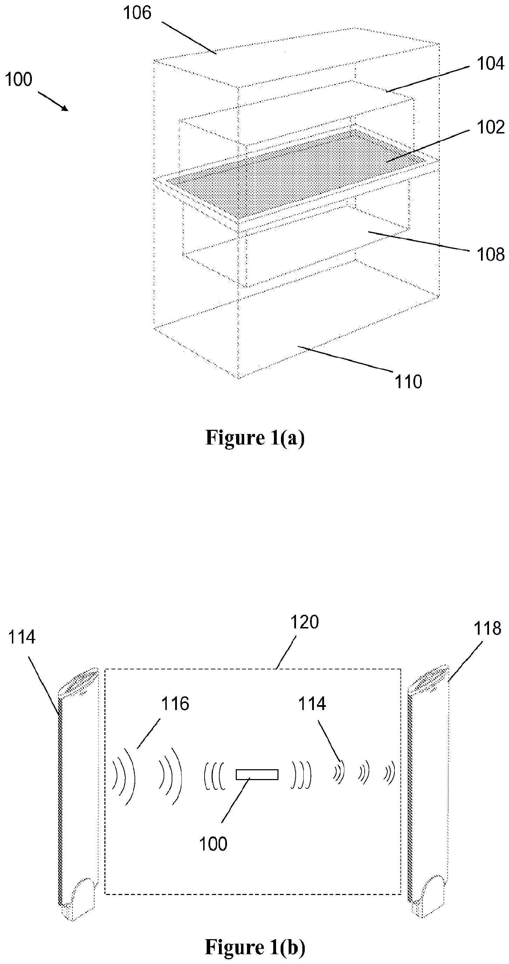

A typical AM label is measured about 45 mm long, 10 mm wide, with an overall thickness of about 1.3 mm. An example of such a label is illustrated in Figure 1. As shown in Figure 1(a), label 100, may include a small cavity 102, which is formed to accommodate one or more active elements 104. Active element 104 is a magnetomechanical metal strip and cavity 102 is formed to allow proper mechanical resonance of the active element. Active element(s) 104 are placed inside cavity 102, and followed by sealing of top cover 106. A strip of semi-hard magnetic bias 108 is located proximate the outside of cavity 102 and active element 104. Finally, marker 100 is completed by adding an adhesive layer with release liner 110.

Figure 1(b) illustrates a typical EAS system employing a marker such as AM marker 100. As shown in Figure 1(b), transmitter pedestal 114 generates an electromagnetic field 116 between it and receiver pedestal 118. The field is typically generated in a series of pulses, which produce regular bursts of electromagnetic energy. The range of the magnetic field defines an "interrogation zone"(120) between the pedestals. When passed through this interrogation zone, active element 104 of AM marker 100 absorbs energy from field 116, and resonates to generate an electromagnetic response signal 122 to the incoming electromagnetic energy from transmitter. To accomplish this, active element 104 is comprised of a strip of high permeability ($\mu$) magnetic material. In addition, it is also a high quality factor (Q) mechanical resonator. The Q can be as high as 3000, depending on the surface friction of the strip during its resonance. Receiver pedestal 118 listens for this response signal in between bursts from transmitter 114, in order to detect the presence of a marker within the interrogation zone. When a marker is detected, the system may then trigger an alarm to alert security.

The active element to be used in the marker may be produced by determining a number of factors in order to achieve an element having the desired properties. For example, this can be accomplished through careful selection of the composition from which the element is formed, and the manner in which the composition is annealed and otherwise processed, mechanically, chemically, and electromagnetically. A number of techniques for optimizing the active element of an EAS marker are known. Some of these are disclosed, for example, in U.S. Patent Nos. 4,510,489; 5,252,144; 5,469,140; 5,469,489; 5,628,840; 6,018,296; and 6,359,563; hereby incorporated herein by reference.

U.S Patent Nos. 6,018,296 and 6,359,563, for example, disclose an FeNi based alloy having low or no cobalt, and with specified amounts of additional elements, M, (such as Si, B, C, P, Ge, Nb, Mo, Cr and Mn) to control how glassy the material is, its formability, and its susceptibility to changes in magnetic properties due to mechanical tension on the material during annealing. These patents focus on the use of quick (around 1 minute or less) heating of the material at higher temperatures (> 300°C) in a reel to reel annealing process to set the magnetic characteristics of the material. In the '296 patent, a batch annealing with a heating time of fifteen minutes at these higher temperatures was also used for comparison to the preferred reel-to reel annealing process.

The '296 patent also states that annealing this material in the presence of a transverse (to the length of the active element ribbon) magnetic field is undesirable because a sufficiently low slope of the frequency response characteristic of the material cannot be achieved at the desired DC bias field operating point of about 6.5 Oe. Conversely, the '563 patent, while it is able to achieve a sufficiently low slope for the frequency response characteristic even with the use of a transverse magnetic field, requires the use of reel to reel annealing at these higher temperatures and shorter annealing times.

Outside factors, such as the cost of raw materials (such as Ni) and/or the high cost of various aspects of processing materials (such as higher temperature reel to reel quick annealing) into final form can change over time, causing the problem that the cost of producing an active element for an EAS marker can become too high. Accordingly, a solution is needed in developing new ways of achieving the same or better performance in an active element for EAS markers in the face of the problem of such higher costs.

SUMMARY OF THE INVENTION

Embodiments of the invention may include a novel composition for and/or processing of an active element for an EAS marker that achieves the same or better performance of existing materials while solving the problem of higher cost. It may include a marker for use in a magnetomechanical electronic article surveillance (EAS) system having a magneto mechanical active element formed by planar strip of amorphous magnetostrictive alloy having a composition $Fe_aNi_bM_c$ wherein a+b+c = 100, wherein a is in a range of 40-70 weight percent, b is in a range of 10-50 weight percent, and c is in a range of 10-50 weight percent, and where M is the balance of remaining elements; wherein the magnetomechanical active element is subject to batch annealing in the presence of a magnetic field that is substantially transverse to the ribbon length of the element and at a temperature of less than about 300°C at a temperature of greater than at least about one hour.

In one embodiment, the balance of remaining elements, M, may include one or more selected from the group consisting of Co, Si, B, C, P, Sn, Cu, Ge, Nb, Mo, Cr, Mn, and Mismetal. Particularly, the material can include about 15-30% of one or more selected from the group consisting of Si, B, C, and P in order to affect the glassy nature of the material. In order to affect magnetic properties of the material, it may include from 0 to about 10% of one or more selected from the group consisting of Sn, Cu, Ge, Nb, Mo, Cr, Mn, and Mismetal. Also, the amount of Ni, b, may particularly be less than about 25 weight percent. The batch annealing is conducted particularly at a temperature of about 250° C for about one hour.

## BRIEF DESCRIPTION OF THE DRAWINGS

For a better understanding of various embodiments of the invention, reference should be made to the following detailed description which should be read in conjunction with the following figures wherein like numerals represent like parts.

Figure 1(a) is an illustration of the construction of an acoustomagnetic marker.
Figure 1(b) is an illustration of an EAS system.
Figure 2 is an illustration of the dependency of a typical resonant frequency of an EAS marker on the external applied DC magnetic field [0016] Figure 3 is an illustration of magnetomechanical resonant amplitudes measured at three time slots, $A_0$, Ai, and $A_2$, with changes with the external DC bias field
Figure 4 is an illustration of the effect of nickel percent concentration on induced field anisotropy in an active element.
Figure 5 is an illustration of the effect of nickel percent concentration on saturation magnetization.
Figure 6 is an illustration of the effect of nickel concentration on Magnitude of magnetostriction.
Figure 7 is an illustration of a comparison of frequency -DC bias dependence of existing active elements for an EAS marker with an active element of the invention.

## DETAILED DESCRIPTION

For simplicity and ease of explanation, the invention will be described herein in connection with various embodiments thereof. Those skilled in the art will recognize, however, that the features and advantages of the invention may be implemented in a variety of configurations. It is to be understood therefore, that the embodiments described herein are presented by way of illustration, not of limitation.

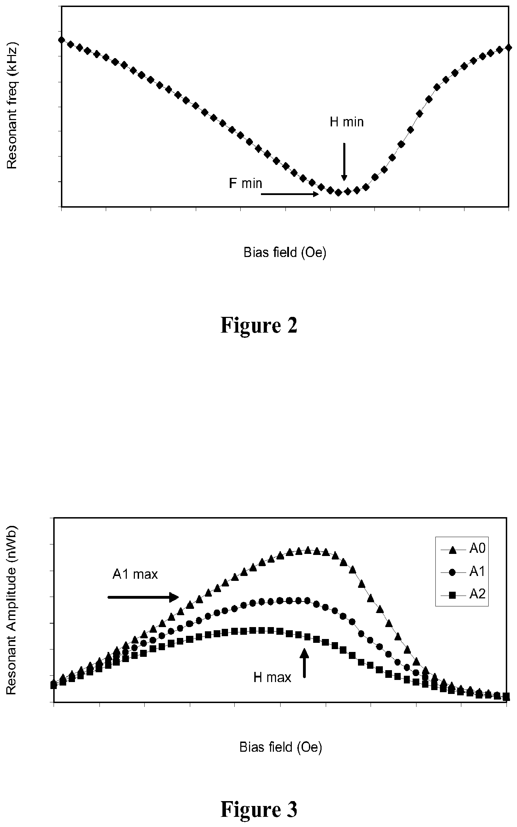

Figure 2 illustrates a typical resonant frequency characteristic of an active element. As can be seen in Figure 2, the resonant frequency of the element varies with the DC field (generated by interaction with the semi-hard bias magnet). As the DC bias field increases, the resonant frequency decreases, until it reaches a minimum ($F_{mm}$) at a bias field of $H_{mm}$ (Oe). The frequency then increases quickly beyond $H_{mm}$. The frequency-bias magnetic field interdependence can be described in Eq. 1 :

$$F_{res} = \frac{1}{2L} \cdot \sqrt{\frac{E/\rho}{1 + \frac{9\lambda^2 E \cdot H^2}{M_s \cdot H_k^3}}} \qquad (1)$$

where E, L, p are the Young's modulus, length, and density of the amorphous strip, and H, $\lambda$, $M_s$, and $H_k$, are the applied DC magnetic field, magnetostriction, saturation magnetization, and transverse (to the ribbon length) anisotropy field, respectively.

The amplitude characteristic of response signal 122 can be demonstrated by taking measurements at three time increments (Ao, Ai, $A_2$) after marker 100 is subject to electromagnetic field 116; for example, at 0, 1, and 2 milliseconds after a burst, as shown in Figure 3. In general, the amplitude increases with DC magnetic field, until reaching a maximum at Hmax, and then starts decreasing gradually with bias field, finally diminishing as the active strip saturated magnetically.

As shown in Figure 2, the peak Of $A_0$, Ai, and $A_2$ shifts toward left (lower DC field), signifying higher Q at lower magnetic field. In general, Ai amplitude represents what receiver pedestal 116 senses. The maximum of Ai, and the bias field when it occurs, are designated as $Ai_{max}$, and $H_{max}$, respectively.

To obtain a usable active element for an EAS marker, several parameters must be optimized to obtain an operating point for the active element / bias in the marker having a desired resonant frequency (such as 58 kHz for AM markers) at a desired DC bias field, typically less than $H_{mm}$. The frequency slope in Hz / Oe at this operating point should preferably be smaller than the maximum slope for the frequency characteristic curve. The Ai amplitude at the operating point should preferably be larger than the minimum amplitude for the amplitude characteristic curve.

For proper function of a deactivatable AM marker, a semi-hard magnetic bias strip is preferably used. This strip is magnetized along the longitudinal direction, in order to provide a DC magnetic field of the desired strength to the active strip. To deactivate the marker, the bias field must be changed to achieve a proper frequency shift. This can be achieved by various methods, including AC demagnetization or magnetization by contacting a patterned magnet. The difference in resonant frequency at the DC bias field of the operating point and the resonant frequency at the DC bias field after deactivation (the deactivation frequency shift, "DFS") should preferably be larger than a selected minimum desired to avoid unintentional detection by receiver pedestal 116.

As can be seen from Eq. 1 above, the frequency / bias field relation may be determined by at least three parameters even if the Young's Modulus and density remain relatively consistent among varying compositions. The frequency profile of the resonator should behave similarly as long as the quantity $C = \lambda^2/(M_8 H_k^3)$ remains relatively constant.

The anisotropy ($H_k$) has the strongest effect since it is cubic. C will also be affected by $\lambda$ and $M_8$. Depending on the value of C, the anisotropic field may include contribution from field induce anisotropy as well as shape anisotropy.

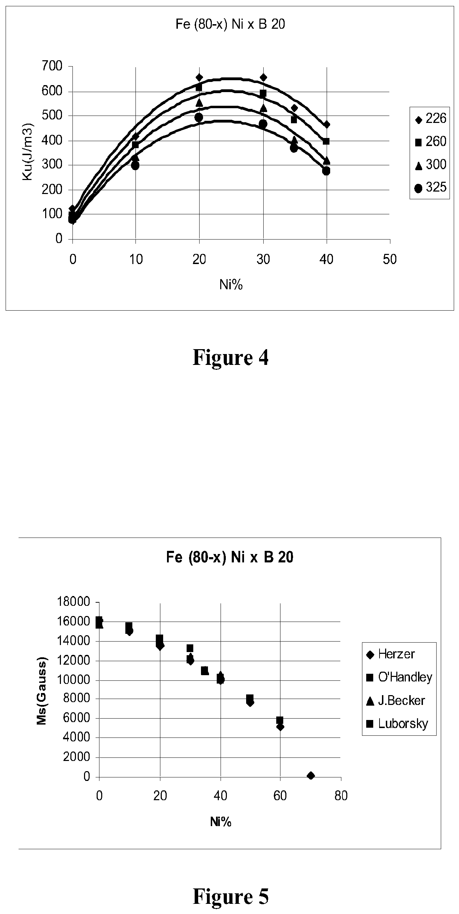

The variation of Ku with Ni % at different temperatures is shown in Figure 4. $H_k$ is a measure of Ku with contribution of $M_s$ given by $H_k = 2 Ku/M_s$. Ku maximizes at around 24% nickel concentration. In addition, Ku also decreases with increased annealing temperature. For an effective short time (around 1 min or less) annealing process, the annealing temperature is set above 300C, and usually at about 360°C. Under these conditions, the maximum Ku attainable at 30% Ni will be roughly about 410 J/m3.

As shown in Figure 4, however, the field induced $H_k$ of an Fe-Ni active element depends strongly on the Ni concentration, as well as on the annealing conditions, specifically the time and temperature of the annealing process. At a fixed annealing time, $H_k$ increases initially as annealing temperature decreases below material Curie Temperature, reaches a maximum, and then decreases as annealing temperature reduced further. Two competing factors, $M_s(T_a)$ - the saturation magnetization at the annealing temperature ($T_a$) and mobility of atoms in the amorphous alloy create the optimum annealing temperature at which the $H_k$ is maximized. At a lower annealing temperature, the saturation magnetization is higher, thus offers a potential of reaching higher $H_k$. However, at that lower temperature, a longer annealing time is necessary for an effective rearranging of the amorphous material in a short range, microscopic scale. Therefore, for the Fe-Ni composition having a lower Ni concentration, the desired Hk still be obtained by lowing the annealing temperature and increasing the annealing time. That is, if a higher field induced anisotropy is desired, annealing with relatively lower annealing temperature, and longer annealing time can be used.

The saturation magnetization is another important parameter. It is directly related to the magnetic signal strength. It also plays a role in forming the resonant frequency and DC magnetic bias relation, as shown in Eq 1. Figure 5 shows the relation of how room temperature saturation magnetization varies with nickel concentration percentage. It is independent of processing / annealing conditions, and decreases monotonically with nickel percent concentration. The anisotropic field (Hk) in this situation may be determined by the following relation:

$$^k = \frac{2 * Ku}{M_s} \quad (2)$$

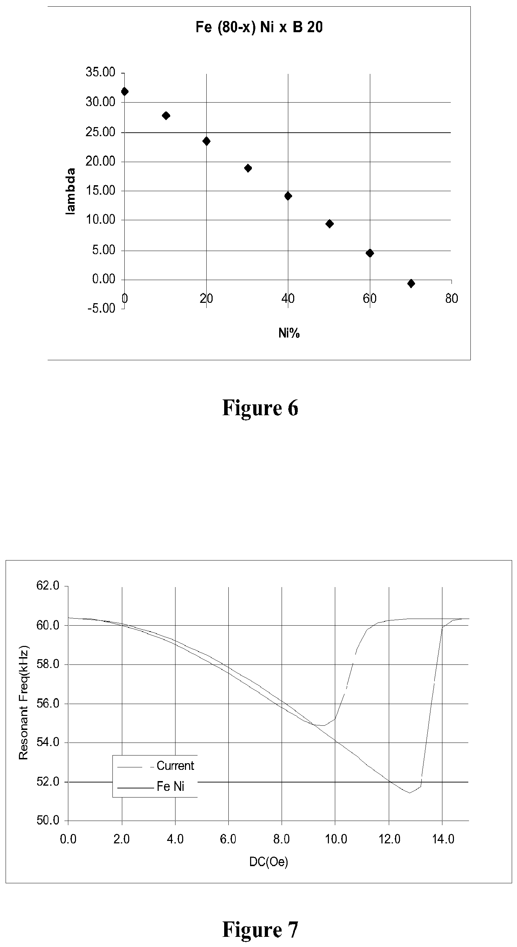

The magnetostrictive constant ($\lambda s$) of the amorphous alloys also depends on Ni percent concentration as shown in Fig. 6. The magnetostrictive constant reduces linearly with increasing Ni % from about 32 ppm at 0% Ni down to about 5 ppm at 60% Ni concentration.

Based on the above information, we have magnetic / mechanical information required to model the magnetomechanical resonance with a Fe-Ni-M amorphous alloy series. A sample composition was modeled comprising $Fe55$-$Ni_25$-$B_20$ The parameters related to the resonant profile for the active element used in this example are listed in Table 1 below:

Table 1 : Magnetic / mechanical parameters of composition model

| $H_k$ (Oe) | $\lambda_s$ (ppm) | $M_s$(kG) | (G Pa) | $\rho$(g/cc) |
|---|---|---|---|---|
| 13,75 | 21 | 13.1 | 162 | 7.76 |

With the material parameters listed in Table 1 , it was determined that a value for C similar to existing active elements could be reached with an $H_k$ value of 12.7 Oe under proper annealing conditions. Figure 7 shows the simulated results on resonant frequency compared to the existing active elements for EAS markers. As shown in Figure 7, the frequency dependence on the DC bias field is very close to the existing elements up to about 9 Oe. In addition, since the saturation magnetization ($M_s$) is much higher, it is expected that the resonant signal magnitude will be higher.

There are also other potential composition variations that can further enhance the strength of the field induce anisotropy. In addition to affecting the glassy nature of the material, a change in the percentage of Si, B, C, and/or P content could potentially increase the Curie temperature of the material which can increase induced $H_k$.

Another potential composition modification to improve the strength of the field induced anisotropy is the addition of low levels of Mn (or, Sn, Cu, Ge, Nb, Mo, and/or Cr). Another approach is to reduce the magnetostriction ($\lambda$) by adding traces of elements, such as chromium (Cr), Niobium (Nb), rare earth (Mismetal - mix of elements). The effect of adding Mn, Cr, or Mo can be to reduce $\lambda_s$, reduce $J_s$, or reduce $H_k$. Mn increases the Creep effect, while Cr reduces it; and Mo has a positive creep effect

Table 2, below, shows data for sputter deposited Fe-Mn-B alloy thin films indicating a significant (3 to 4 Oe) increase in $H_k$ for small amount (0.5%) of Mn additions to Fe-B. This increase is much greater than that obtained by Ni additions to Fe-B, which are typically less than 1 Oe for each atomic % Ni added. To further reduce the materials cost of the alloy, small amounts of Mn could be included in combination with reduced amounts of Ni.

Table 2: Field induced anisotropy of as-deposited sputtered FeMnB alloys.

| %Fe | %B | %Mn | $H_k$ |
|---|---|---|---|
| 80 | 20 | 0 | 11.76 |
| 79.5 | 20 | 0.5 | 15.35 |
| 73 | 27 | 0 | 10.57 |
| 72.5 | 27 | 0.5 | 14.53 |

Several samples were prepared and tested to demonstrate the invention. These samples are listed below in Table 3:

Table 3: Sample Compositions

| Sample | Composition (atomic weight %) | Density (g/cc) | Js (T) | $\lambda$s (ppm) |
|---|---|---|---|---|
| 1 | 58Fe-24Ni-1Si-17B | 7.54 | 1.38 | 30.3 |
| 2 | 52Fe-30Ni-1Si-17B | 7.60 | 1.28 | 26.7 |
| 3 | 54Fe-24Ni-1Si-21B | 7.50 | 1.26 | 24.2 |
| 4 | 48Fe-30Ni-1Si-17B | 7.57 | 1.14 | 20.5 |
| 5 | 53Fe-27Ni-1Si-19B | 7.55 | 1.26 | 24.4 |
| 6 | 52Fe-27Ni-1Mn-1Si-19B | 7.55 | 1.23 | 23.9 |
| 7 | 51Fe-27Ni-2Cr-1Si-19B | 7.54 | 1.13 | 20.6 |
| 8 | 51Fe-27Ni-2Mo-1Si-19B | 7.62 | 1.11 | 19.2 |

These samples were batch annealed, which is much lower in cost to reel to reel annealing. The samples were also subject to a transverse magnetic field during annealing. For different annealing temperatures, different soaking times were used. For 200°C, the soaking time was 2.5 days. At 250°C, the soaking time was at least 7 hours. For 300 and 350°C the soaking time was 10 minutes or more. The resulting $H_k$ for each sample at each annealing temperature is shown in Table 4 below:

Table 4: Values of $H_k$ at each annealing temperature

| Sample# | 1 | 2 | 3 | 4 | 5 | 6 | 7 | 8 |
|---|---|---|---|---|---|---|---|---|
| 200°C | 12.8 | 13.7 | 9.9 | 9.8 | 11.7 | 10.5 | 9.7 | 9.6 |
| 250°C | 13.3 | 14.4 | 10.5 | 10.9 | 12.0 | 11.3 | 9.6 | 9.2 |
| 300°C | 12.7 | 13.5 | 10.4 | 9.9 | 11.8 | 10.5 | 8.5 | 8.3 |
| 350°C | 11.9 | 12.4 | 10.0 | 9.1 | 11.0 | 9.6 | 7.5 | 6.3 |

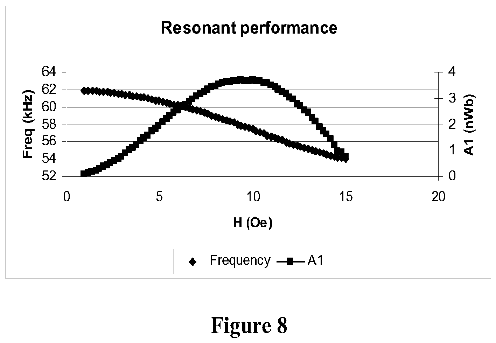

The resonant performance of sample # two, batch annealed in the presence of a transverse magnetic field at 250°C for about one hour is shown in Figure 8. As can be seen from Figure 8 and the preceding information, an active element with parameters that would yield performance on par with existing EAS resonator element can be achieved in a composition having Fe in the range of 40-70 atomic weight percent, Ni in a range of 10-50 atomic weight percent, and the remaining elements in a range of 10-50 weight percent that is batch annealed in the presence of a transverse magnetic field at a temperature below 300°C and for a time greater than at least one hour.

It is to be understood that variations and modifications of the various embodiments of the invention can be made without departing from the scope of the invention. It is also to be understood that the scope of the invention is not to be interpreted as limited to the specific embodiments disclosed herein, but only in accordance with the appended claims when read in light of the forgoing

**Claims**

1.    A method of manufacturing a marker for use in a magnetomechanical electronic article surveillance (EAS) system, the method comprising the steps of:

     - providing a magnetomechanical active element formed by planar strip of amorphous magnetostrictive alloy having a composition $Fe_3M_bM_0$ wherein a+b+c = 100, wherein a is in a range of 40-70 weight percent, b is in a range of 10-50 weight percent, and c is in a range of 10-50 weight percent, and where M is the balance of remaining elements;
     - subjecting the magnetomechanical active element to an annealing process for rearranging of the amorphous material in a short range, microscopic scale.

2.    Method of Claim 1, wherein M is one or more selected from the group consisting of Co, Si, B, C, P, Sn, Cu, Ge, Nb, Mo, Cr and Mn.

3.    Method of Claim 1, wherein M comprises one or more selected from the group consisting of Si, B, C, and P.

4.    Method of Claim 3, M is from about 15 to about 30 weight percent.

5.    Method of Claim 1, wherein M comprises one or more selected from the group consisting of Sn, Cu, Ge, Nb, Mo, Cr, Mn, and Mismetal.

6.    Method of Claim 5, wherein M is from about 0 to about 10 weight percent.

7.    Method of Claim 1, M comprises one or more first elements selected from the group consisting of Si, B, C, and P to affect the glassy nature of said active element; and one or more second elements selected from the group consisting of Sn, Cu, Ge, Nb, Mo, Cr, Mn and Mismetal to affect the magnetic properties of said active element.

8.    Method of claim 7, wherein said first element comprises about 15 to about 30 weight percent of said active element, and said second element comprises about 0 to about 10 weight percent of said active element.

9.    Method of claim 1, wherein the amount of Ni, b, is less than about 25 weight percent.

10.    A marker for use in a magnetomechanical electronic article surveillance (EAS) system, wherein the marker is manufactured by a method according to any of the preceding claims.

**Figure 1(a)**

**Figure 1(b)**

**Figure 2**

**Figure 3**

**Figure 4**

**Figure 5**

**Figure 6**

**Figure 7**

**Figure 8**

Europäisches
Patentamt

European
Patent Office

Office européen
des brevets

# EUROPEAN SEARCH REPORT

Application Number

EP 17 21 0712

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 702 096 A (VACUUMSCHMELZE GMBH [DE]) 20 March 1996 (1996-03-20) * page 2, line 7 - line 17; table 1 * * page 2, line 38 - line 41 * ----- | 1-10 | INV. G08B13/24 H01F10/13 H01L41/20 |
| X | GB 2 156 630 A (ALLIED CORP) 9 October 1985 (1985-10-09) * page 4, line 51 - line 53; claim 7; figures 4,5; table 1 * ----- | 1-10 | |
| X | WO 90/03652 A (ALLIED SIGNAL INC [US]) 5 April 1990 (1990-04-05) * page 16, line 12 - line 27; claim 10; table 1 * ----- | 1-10 | |
| | | | TECHNICAL FIELDS SEARCHED (IPC) H01F G08B H01L |

The present search report has been drawn up for all claims

| Place of search | Date of completion of the search | Examiner |
|---|---|---|
| Munich | 30 May 2018 | Primus, Jean-Louis |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 17 21 0712

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2018

| Patent document cited in search report | | Publication date | Patent family member(s) | | Publication date |
|---|---|---|---|---|---|
| EP 0702096 | A | 20-03-1996 | DE | 9412456 U1 | 27-10-1994 |
| | | | EP | 0702096 A1 | 20-03-1996 |
| | | | JP | H0860312 A | 05-03-1996 |
| GB 2156630 | A | 09-10-1985 | DE | 3509160 A1 | 26-09-1985 |
| | | | GB | 2156630 A | 09-10-1985 |
| | | | JP | S60211598 A | 23-10-1985 |
| | | | US | 4622543 A | 11-11-1986 |
| WO 9003652 | A | 05-04-1990 | | | |

For more details about this annex : see Official Journal of the European Patent Office, No. 12/82

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 81128006 P
- US 4510489 A
- US 5252144 A
- US 5469140 A
- US 5469489 A
- US 5628840 A
- US 6018296 A
- US 6359563 A
- US 6359563 B